# EUROPEAN PATENT SPECIFICATION

(11) **EP 1 792 517 B1**
(45) Date of publication and mention of the grant of the patent: **10.04.2013**
(21) Application number: 05786893.7
(22) Date of filing: 05.09.2005
(51) Int. Cl.: H04R 19/04, H04R 19/00, H01L 23/31

(54) **Audio processing device with encapsulated electronic component.**
Audioverarbeitungsvorrichtung mit eingekapselter elektronischer Komponente
Dispositif de traitement audio avec composant électronique encapsule

(30) Priority: 13.09.2004 DK 200401385
(43) Date of publication of application: 06.06.2007
(73) Proprietor: Oticon A/S, 2765 Smørum (DK)
(72) Inventor: RASMUSSEN, Frank Engel, c/o Oticon A/S, DK-2765 Smorum (DK); SKINDHØJ, Jørgen, c/o Oticon A/S, DK-2765 Smorum (DK); PETERSEN, Anders Erik, c/o Oticon A/S, 2765 Smorum (DK)
(86) International application number: PCT/EP2005/054355
(87) International publication number: WO 2006/029970

(56) References cited:
- US-A- 5 220 489
- US-A1- 2002 102 004
- US-A1- 2003 133 588
- US-B1- 6 522 762
- US-B1- 6 732 588

## Description

### AREA OF THE INVENTION

The invention concerns an audio processing device with an electronic component such as a chip, which has been encapsulated. Such an encapsulation is common and serves the purpose of protecting sensitive components against light and other environmental exposures. The encapsulation is usually achieved in an injection moulding process, wherein the chip and PCB substrate is enclosed in a mould and the encapsulation material is injected into the mould cavity around the electronic component and caused to solidify in the closed mould, where after the electronic component with the solid encapsulation material is removed from the mould cavity. Other ways of moulding the encapsulation are known, such as dispensing material onto and around the electronic component, and subsequently solidifying the material.

### BACKGROUND OF THE INVENTION

In audio devices such as hearing aids and headsets where small size is very important, it is desirable that the PCB remains as small as possible. Also the encapsulation should take up as little volume as possible. Further mounting area for further electronic parts like capacitors, contacts and antennas should remain as small as possible in order to minimize the volume of the PCB.

US 6522762 discloses a stacked silicon device with a first silicon device and at least two separate silicon devices stacked onto the first device. An EMI shield in the shape of a conductive layer such as a conductive epoxy or electroplated Cu or Au is provided to cover at least a part of the surfaces of the IC stack.

In prior art document US 5220489 an electronic package is disclosed, comprising a circuit substrate, such as a flexible PCB having opposed first and second surfaces, said first surface having a plurality of solderable interconnections and said second surface having a first circuitry pattern; a semiconductor device mechanically mounted on the second surface of the circuit substrate and electrically connected to the first circuitry pattern; a molded body completely encapsulating the semiconductor device and substantially covering the first surface of the circuit substrate; a layer of metal deposited directly on the molded body, said layer formed into a second conductive circuitry pattern connected to at least the first conductive circuitry pattern; and at least one electronic component mounted on the molded body and electrically connected to the second conductive circuitry pattern.

### SUMMARY OF THE INVENTION

The invention provides an audio device with at least one encapsulated electronic component. The encapsulated component is mounted and electrically connected to a substrate and further electric components are mounted for connection with the encapsulated component through the substrate. The encapsulated component is protected by an encapsulation material moulded onto the substrate. According to the invention at least one metal layer is deposited on a surface part of the encapsulation material. The metal layer provides a very dense and effective light protection, and as such may allow a very thin layer of encapsulation material to be used. The encapsulated component, possibly a chip may be accompanied by one or several other electric components, all of which are embedded in the encapsulation material.

In a further embodiment the metal layer on the encapsulation material is provided as conductive metal traces and electric components are formed onto or mounted onto the surface of the encapsulation such that the components are connected with the leads in the substrate through the metal traces. By having electric components on the surface of the encapsulation material more space becomes available for mounting purposes as components like capacitors and resistors are mountable on top of the chip and the metal traces will provide the connection between the components and the PCB.

In a further embodiment the metal layers or traces form capacitors, coils, antennas or other active or passive devices on the encapsulation material. This allows such components to be generated in a very space saving manner.

In a further embodiment the encapsulation material comprise cavities or other surface structures, serving as part of, or receiving elements for individual components. Such surface structures are provided simply by providing mirror images thereof in the mould used for the moulding of the encapsulation. The provision of metal traces can be caused to follow possible cavities or raised areas on the surface of the material. The individual component mounted in or on cavities or other surface structures may comprise microphone or receiver parts or other transducer elements.

The invention further comprise a method for producing an amplifier for an audio device whereby an electronic component is mounted on and electrically connected to a PCB and where an encapsulation material is provided to protect the electronic component wherein further a metal layer is generated at least on a surface area of the encapsulation material. Preferably the encapsulated component comprises a semiconductor chip.

In an embodiment of the method the metal layer is deposited by an electrochemical deposition method. Such methods are known in connection with MID techniques developed in recent years. Here, the surface material of the encapsulation must have special properties, which allows the deposition of a metal layer. This is achieved by the addition to the encapsulation material of a compound comprising an organic metal complex which is activated in the areas where the metal is to be deposited. The activation step may be performed by treatment with laser light, and this allows electrically conductive, thin traces to be deposited on the surface. The compound comprising the organic metal complex can be provided as part of the encapsulation material in only the areas wherein the metal is to be deposited. Here a two component moulding technique could be used.

In a further embodiment of the method according to the invention, the metal layer is deposited through a nozzle directly onto the surface of the chip encapsulation material. In this procedure an aerosol stream is focused, deposited, and patterned onto the surface of the encapsulation material. The surface need not be planar to perform this process. After deposition of the material thermal annealing or photochemical annealing using laser decomposition is performed in order to achieve physical and/or electrical properties near that of the bulk material.

Other ways to deposite metal layers on top of the encapsulation material may be used according to the invention. The entire surface may be electroplated and later the metal may be stripped off by burning in the areas where no metal is desired.

### BRIEF DESCRIPTION OF THE DRAWINGS

Fig. 1 is a side view of an audio device according to the invention,
Fig. 2 shows an embodiment corresponding to fig. 1, but were a component is mounted underneath the microphone membrane,
Fig. 3 shows an example of the invention where a push button is provided on top of the chip,
Fig. 4 is an embodiment, wherein a reed switch is mounted partially embedded in a cavity over the chip,
Fig. 7 is a perspective view of part of a PCB with rows of IC-devices mounted thereon,
Fig. 8 shows the PCB of fig. 7, but now with the encapsulation material moulded onto the PCB,
Fig 9 a perspective view of leads formed onto the chip encapsulation and the PCB,
Fig. 10 is the device shown in fig. 9, but now with components mounted onto top of the chip encapsulation.

### DESCRIPTION OF A PREFERRED EMBODIMENT

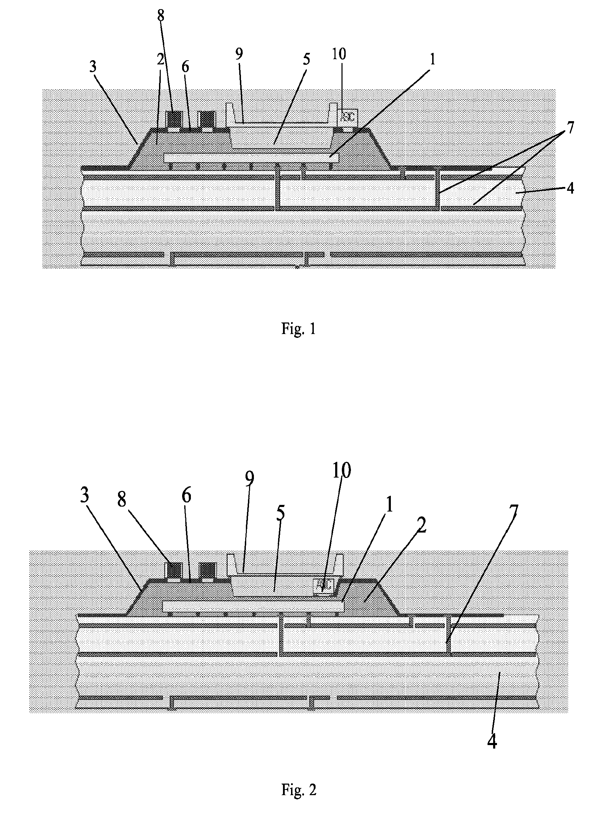

Fig. 1 shows a part of a hearing aid amplifier with a chip 1 which is covered by an encapsulation material 2. On top of the encapsulation material 2 a metal layer 3 is provided. In this case the chip is mounted by traditional flip chip technology on a flexible PCB 4. Any other PCB may however be used. The encapsulation is provided by means of transfer moulding. As can be seen in fig. 1 a cavity 5 is created in the upper part of the encapsulation material 2. The transfer moulded encapsulation 2 is metallized on parts of the surface to create a redistribution circuitry 6. The redistribution circuitry 6 on the chip encapsulation 2 is preferably connected to the chip 1 via metal lines 7 embedded in and on the flex print 4. In the displayed embodiment a chip is being encapsulated, but other components could be encapsulated according to the invention.

After metallization, components 8,9,10 are mounted followed by reflow soldering. In this case the remaining components are SMD's 8 and a membrane chip 9. The membrane chip 9 constitutes part of a microphone such that when it is added on top of the cavity 5 a silicon microphone is created. Further an ASIC 10 for preamplification and signal processing is shown in fig. 1 as a possible component mounted on top of the chip encapsulation.

In fig. 2 basically the same structure is displayed. Here however the preamplifier 10 is placed in the cavity 5. This will assure some protection of the delicate ASIC 10 circuitry and further it will allow other components to be mounted onto the limited available area.

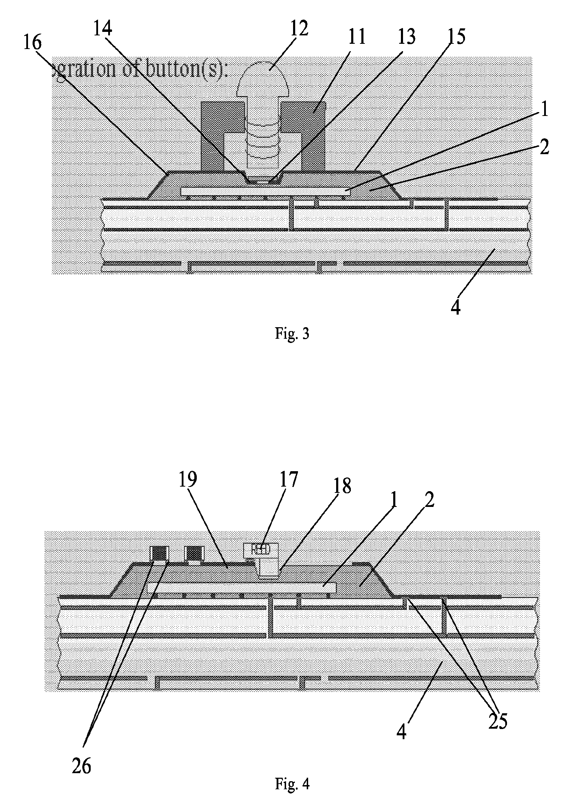

In fig. 3, the area on top of the chip 1 is used for a push button. The button comprises a housing 11 and an actuator part 12. When the actuator 12 is depressed an electric connection is created between two contact points 13, 14 on top of the encapsulation material 2. Two leads 15, 16 connects the contact points 13, 14 with the circuitry and the chip 1.

Fig. 4 displays a further embodiment of the invention. Here a small reed switch 17 is arranged on top of the encapsulation material 2. A cavity 18 is provided for a protruding part of the reed switch to assure that the switch uses only a minimum of space and is mechanically stabilized. Electric leads 19 connects the reed switch with the circuitry and the chip 1.

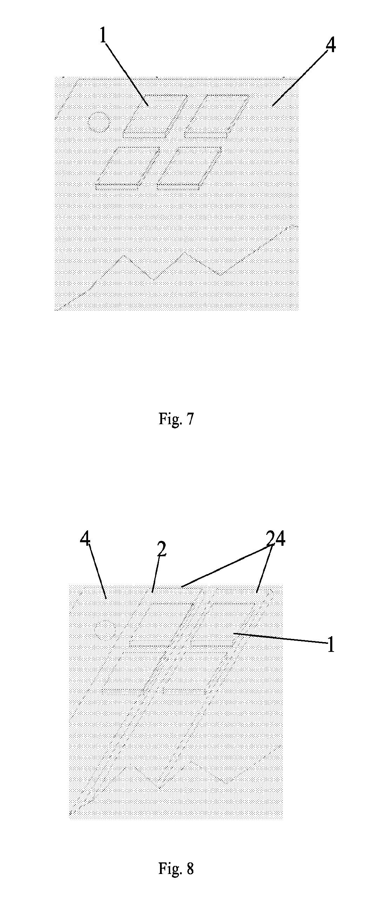

In Figs. 7, 8, 9 and 10 the process for generating the audio processing device is exemplified. In fig. 7 a part of a PCB board 4 with the IC devices 1 is shown. The IC's 1 are in electric contact with the circuitry of the PCB 4 through wire bonding or by solder bump bonding or other connecting means known in the art. As seen the IC silicon devices 1 are mounted in rows. In fig. 8 it is shown how each row of IC's becomes over-moulded with the encapsulation material 2. This is done by placing the entire board 4 in a mould which has a cavity 24 for each row of IC's and then filling out the cavity 24 with liquid encapsulation material 2. The material is then caused to solidify whereafter the PCB 4 is removed from the mould. The mould may comprise surface structures over or near the silicon IC devices 1.

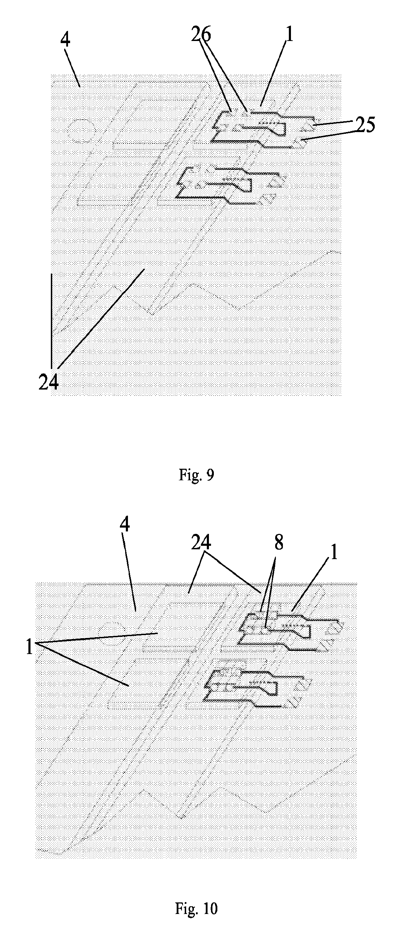

Following this step, metal traces 6 are formed on the encapsulation material 2 and as shown in the example of fig. 9 and in figs. 1-6 connection leads 6 are generated between pads 25 on the PCB 4 and pads 26 on surface parts of the encapsulation material 2.

The entire PCB board 4 is then run through a pick and place automat wherein electric components 8 are mounted on the pads 26 on the encapsulation surface. Hereafter the PCB is run through a soldering tunnel, causing the components to be fastened to the surface and electrically connected to the pads. The resulting array of devices with the mounted components is seen in fig. 10.

The audio devices are then singularized, preferably by sawing the PCB, whereafter they are ready for use in hearing aids or other audio processing equipment. In the description above each device contain only one chip, but multi chip devices are easily provided by chip-on-chip mounting or by mounting chips side by side on the same PCB.

Two ways of generating the metal on top of the encapsulation material is described in more detail in the following. The first way comprises electrochemical deposition of metal in traces or covering larger surfaces. Here the surface of the chip encapsulation material is activated to provide catalytic sites for the metal deposition. The activation results in inclusion of precious metal ions (Pd, Pt, Au, etc.) in the surface of the encapsulation. The inclusion of the metal ions in the surface is obtained either by photochemical dissociation of an organic metal complex, which has been added to the encapsulation material and which contains the precious metal, or by sequentially treating the surface in dedicated micro-etch, pre-activator and activator solutions. Here the later provides the precious metal ions. In the photochemical dissociation the organic metal complex in the chip encapsulation material is cracked open by a focused laser beam and the metal atoms are broken off from organic ligands. The metal atoms then act as nuclei for reduction of metal ions during a subsequent electrochemical deposition process. The laser activation is performed in traces to provide electric connection to discrete components as disclosed above or along larger areas to allow protective layers of metal to be formed on selected areas.

After surface activation metal is electrochemically deposited either by electroless plating or by electroplating. In situations where the electrochemically deposited metal is not allowed to be deposited elsewhere on the PCB, the metallic pads for wirebonding, solder bump bonding, etc. must be protected/masked during metal deposition. This is done by covering the pads with a layer of polyimide, which is later ablated by a laser in order to re-open the pads.

A second way of providing metal layers on the encapsulation material is Maskless Mesoscale Materials Deposition, also known as M3D technology. This process is promoted by Optomec, www.optomec.com. Here aerodynamic focusing is used in a maskless deposition of chemical precursor solutions and colloidal suspensions. An aerosol stream is focused, deposited, and patterned onto the surface of the encapsulation material. Also un-even surfaces with cavities as disclosed above are provided with metal layering. A thermal annealing or photochemical (laser decomposition) process to achieve physical and/or electrical properties near that of the bulk material follows the deposition.

## Claims

1. Audio processing device with at least one semiconductor chip (1) mounted and electrically connected to electric leads in a flexible PCB (4) and where further electric components are mounted onto the flexible PCB (4) for connection with the semiconductor chip (1) through the flexible PCB (4) and where encapsulation material (2) is moulded onto the flexible PCB (4) and encapsulates the semiconductor chip (1) whereby at least one metal layer is deposited on a surface part of the encapsulation material and provided as conductive metal traces which are electrically connected with the leads in the flexible PCB (4) and whereby an electric component is formed on or mounted onto the surface of the encapsulation material and connected with the leads in the substrate through the metal traces ***characterized in that*** the encapsulation material comprises cavities or other surface structures, serving as part of, or receiving means for the electrical component.

2. Audio processing device as claimed in claim 1 whereby the metal layers or traces form capacitors, coils, antennas or other active or passive devices on the encapsulation material.

3. Method for producing an amplifier for an audio device whereby at least one semiconductor chip (1) is mounted on and electrically connected to a flexible PCB (4) and where an encapsulation material (2) is provided to protect the at least one semiconductor chip (1), wherein further a metal layer is generated at least on a surface area of the encapsulation material (2), wherein the surface of the encapsulation material (2) is provided with cavities or other surface structures during moulding of the encapsulation material onto the PCB (4).

4. Method as claimed in claim 3, whereby an acoustic transducer part is mounted onto a cavity structure of the encapsulation material (2) and gains contact with other electric components through the electric lead on the surface of the encapsulation material (2).

5. Method as claimed in claim 3, wherein the metal layer is deposited by an electrochemical deposition method.

6. Method as claimed in claim 5, wherein the metal layer is deposited through a nozzle directly onto the surface of the chip encapsulation material.

## Patentansprüche

1. Audioverarbeitungsgerät mit mindestens einem Halbleiterchip (1) der montiert und elektrisch verbunden ist mit elektrischen Leitungen in einer flexiblen Leiterplatte (4) und wobei weitere elektrische Komponenten auf die flexible Leiterplatte (4) zur Verbindung mit dem Halbleiterchip (1) durch die flexible Leiterplatte (4) montiert sind und wobei ein Einkapselungsmaterial (2) auf die flexible Leiterplatte (4) geformt ist und den Halbleiterchip (1) einkapselt, wobei zumindest eine Metallschicht auf einer Teiloberfläche des Einkapselungsmaterials abgeschieden und als leitende Metallbahnen, die mit den Leitungen der flexiblen Leiterplatte (4) elektrisch verbunden sind, vorgesehen sind, und wobei elektrische Komponenten (8, 9, 10) auf der Oberfläche des Einkapselungsmaterials geformt oder darauf montiert und mit den Leitungen in dem Substrat durch die Metallbahnen verbunden sind, **dadurch gekennzeichnet, dass** das Einkapselungsmaterial Vertiefungen oder andere Oberflächenstrukturen aufweist, die als Teil der oder als Aufnahmemittel für zumindest eine der elektrischen Komponenten (8, 9, 10) dienen.

2. Audioverarbeitungsgerät gemäß Anspruch 1, wobei die Metallschichten oder Bahnen Kondensatoren, Spulen, Antennen oder andere aktive oder passive Teile auf dem Einkapselungsmaterial formen.

3. Verfahren zum Herstellen eines Verstärkers für ein Schallverarbeitungsgerät gemäß Anspruch 1, bei dem die Oberfläche des Einkapselungsmaterials (2) während des Formens des Einkapselungsmaterials auf die Leiterplatte (4) mit Vertiefungen versehen wird.

4. Verfahren gemäß Anspruch 3, bei dem ein Schallwanderteil auf eine Vertiefungsstruktur des Einkapselungsmaterials (2) montiert wird und mit anderen elektrischen Komponenten durch elektrische Leitungen auf der Oberfläche des Einkapselungsmaterials (2) Kontakt erhält.

5. Verfahren gemäß Anspruch 3, bei dem die Metallschicht durch ein elektrochemisches Abscheideverfahren abgeschieden wird.

6. Verfahren gemäß Anspruch 5, bei dem die Metallschicht mittels einer Düse direkt auf die Oberfläche des Chip-Einkapselungsmaterials abgeschieden wird.

## Revendications

1. Dispositif de traitement audio avec au moins une puce semi-conductrice (1) montée et reliée électriquement à des conducteurs électriques dans un circuit imprimé flexible (4) et où d'autres composants électriques sont montés sur le circuit imprimé flexible (4) pour un raccordement avec la puce semi-conductrice (1) par le circuit imprimé flexible (4) et où un matériau d'encapsulation (2) est moulé sur le circuit imprimé flexible (4) et encapsule la puce semi-conductrice (1) de sorte qu'au moins une couche métallique est déposée sur une partie de surface du matériau d'encapsulation et fournie sous la forme de traces métalliques conductrices qui sont connectées électriquement avec les conducteurs dans le circuit imprimé flexible (4) et de sorte que les composants électriques (8, 9, 10) sont formés sur ou montés sur la surface du matériau d'encapsulation et reliés avec les conducteurs dans le substrat par les traces métalliques, **caractérisé en ce que** le matériau d'encapsulation comprend des cavités, servant en tant que partie de, ou moyen de réception pour, au moins l'un desdits composants électriques (8, 9, 10).

2. Dispositif de traitement audio selon la revendication 1 dans lequel les couches métalliques ou traces forment des condensateurs, des bobines, des antennes ou d'autres dispositifs actifs ou passifs sur le matériau d'encapsulation.

3. Procédé de fabrication d'un amplificateur pour un dispositif de traitement audio selon la revendication 1, dans lequel la surface du matériau d'encapsulation (2) est pourvue de cavités pendant le moulage du matériau d'encapsulation sur le circuit imprimé (4).

4. Procédé selon la revendication 3, dans lequel une partie de transducteur acoustique est monté sur une structure de cavité du matériau d'encapsulation (2) et entre en contact avec d'autres composants électriques par l'intermédiaire du conducteur électrique sur la surface du matériau d'encapsulation (2).

5. Procédé selon la revendication 3, dans lequel la couche métallique est déposée par un procédé de dépôt électrochimique.

6. Procédé selon la revendication 5, dans lequel la couche métallique est déposée par une buse directement sur la surface du matériau d'encapsulation de puce.
